Europäisches Patentamt

European Patent Office

Office européen des brevets

(19)

(11) Publication number: **0 161 805**
**A1**

# EUROPEAN PATENT APPLICATION

(12)

(21) Application number: **85302569.0**

(22) Date of filing: **12.04.85**

(51) Int. Cl.⁴: **H 01 B 1/22,** H 01 B 1/24

(30) Priority: **12.04.84 US 599515**

(43) Date of publication of application: **21.11.85**
**Bulletin 85/47**

(84) Designated Contracting States: **AT BE CH DE FR GB IT
LI LU NL SE**

(71) Applicant: **ELECTRO MATERIALS CORP. OF AMERICA,
605 Center Avenue, Mamaroneck New York 10543 (US)**

(72) Inventor: **Lane, George, 7 MacIntosh Lane, Monsey New
York 10952 (US)**
Inventor: **Martin, Frank Wayne, P.O. Box 243, Baldwin
Place New York 10505 (US)**
Inventor: **St. John, Frank, 1 Webster Place, Patterson
New York 12563 (US)**

(74) Representative: **Angell, David Whilton, Rohm and Haas
Company Patent Department Chesterfield House
Bloomsbury Way, London WC1A 2TP (GB)**

(54) **Peelable electrically conductive material.**

(57) The invention concerns a composition which may be used
to form a temporary conductor or resistor, for example, by
screen printing onto selected parts of an electrical circuit and
peeled off when desired. The composition comprises vinylic
resin, wax, solvent, and conductive and/or semiconductive
particles.

EP 0 161 805 A1

## PEELABLE ELECTRICALLY CONDUCTIVE MATERIAL

This invention concerns a composition which may be used to form a temporary conductor or resistor which may be screen printed onto selected parts of a circuit and then peeled off when desired.

In the case of electronic devices subject to electromagnetic radiation interference during testing, a known technique for protecting the device undergoing testing involves the use of a specially constructed metallic enclosure.

A less expensive and more versatile method for accomplishing protection of an electronic device during testing is offered by the present invention when the composition of the invention is in the form of a resistor composition. Such a resistor composition can be applied, as a protective coating, to selected portions of the object to be protected by the simple process of screen printing, brushing or dipping and this protective coating will shield the portions so covered.

When the composition of the present invention is in the form of a conductor composition, such a conductor composition offers an improved means of providing a temporary conductor in an electrical circuit. The prior art technique of soldering-in temporary jumpers or using shorting clamps is burdensome and unreliable. Such a temporary conductor according to the present invention can be conveniently screen printed onto a circuit board and peeled off when no longer desired.

The use of conductive inks is generally known in the art. For example, U.S. Patent-A-4,406,826 to Morgan et al. teaches a conductive composition comprising electrically conductive particles embedded in resinous material formed from two different ethylenically unsaturated monomers, oligomers, or prepolymers, in combination with a polythiol compound and a thermal initiator. This composition is screen printable and heat curable. However, the composition forms a film which is not intended to be temporary. Once the ink is printed on the substrate, it is not peelable and is actually formulated to have resistance to removal.

U.S. Patent-A-2,959,498 to Sweeney teaches a conductive circuit composition bonded to a resinous dielectric. The conductive composition comprises finely divided silver mixed with a thermoplastic resin and a solvent. The resin may be normal or isobutyl methacrylate, polyvinyl acetate, or polyvinyl chloride. The composition, however, is not peelable or easily removed. On the contrary it is intended to be permanently and firmly adhered to the resinous dielectric base. A thermosetting undercoat on the dielectric base, which is cured simultaneously with the conductive film, serves to provide essentially irreversible adherence to the substrate.

U.S. Patent No. Re. 31, 411 to Bolon et al. teaches radiation curable inks which result in a conductive coating. The ink comprises a radiation curable resin and an electrically conductive filler such as silver or copper-containing particles. Bolon et al. also teaches that small amounts of paraffin may be included with the resin to reduce oxygen inhibition which manifests itself as surface tack. The inclusion of the wax is not taught as having any effect on the peelability of the conductive coating.

In contrast to the above mentioned prior art conductive inks, the screen printable composition of the present invention forms a film which possesses the combined properties of being (a) conductive or semiconductive, and (b) peelable.

By practice of the present invention there may be provided one or more of the following:-

> (i)  a conductive ink which is not only screen printable, but which forms a film which is peelable and therefore readily removable after application to a substrate;

(ii)     a conductive ink for a film which is capable of
         providing temporary electrical shorts at
         strategic locations in a circuit, without the
         necessity of soldering in temporary jumpers or
         applying mechanical clamps;

(iii)    a heat curable, thick film conductor which
         provides satisfactory adherence in a temporary
         capacity, but which is readily removed by
         peeling off, without the necessity of abrasives
         or special solvents;

(iv)     a peelable, thick film conductor which when
         peeled off from a substrate, leaves a clean and
         unaffected surface on the substrate; and

(v)      a versatile and inexpensive means of protecting
         an electronic device from electromagnetic
         radiation interference during testing of the
         device.

According to one aspect of the present invention
there is provided a composition adapted to form an
electrical conductor or resistor on a substrate, said
conductor or resistor having a desired conductivity and
being capable of being removed from said substrate by
peeling therefrom, said composition comprising

(i)      5-20% by weight vinylic resin,

(ii)     2 to 6% by weight wax,

(iii)    20 to 60% by weight solvent, and

(iv)     up to 60% by weight of conductive particles
         and/or up to 20% by weight of semiconductive
         particles, selected to provide the desired
         conductivity of said conductor or resistor,

the above percentages being based on the total weight of
(i), (ii), (iii) and (iv), and the weight ratio of said
vinyl resin to said wax being in the range of 2:1 to 4:1 to
allow the conductor or resistor to be removed from said
substrate by peeling.

As used herein in connection with the present invention, the term "vinylic resin" is intended to include any resin containing one or more units of vinyl or vinylidene monomer.

The electrically conductive particles, which may be present in the composition of the invention, e.g. when the composition is in the form of a conductive composition, may be in the form of particles, spheres, beads, powder, fibers, flakes or mixtures thereof. The preferred material is silver, preferably in the form of flakes. Other employable metals are gold, silver, platinum and nickel.

The conductive particles which may be employed in the present invention can vary in dimensions, depending on the particular form of the particles. The particles suitably have a dimension in the range of about 0.1 to 50 micrometres. The silver flakes of the preferred conductive composition have an average length of about 2 micrometres.

The conductive particles may suitably be present in an amount of up to 60%, e.g. from 20 to 60% by weight, based on the total weight of vinylic resin, solvent, wax, conductive particles and, if present, semi-conductive particles. The preferred range is 20 to 50% by weight, and most preferably from about 35 to 45% by weight.

The semi-conductive particles which may be present in the composition of the present invention, e.g. when the composition is in the form of a resistor composition, may comprise carbon particles. The carbon particles may be in the form of either carbon black or graphite. A particle size of .1 to 10 micrometres is preferred.

The semi-conductive particles, e.g. carbon particles, are suitably present in the resistor composition in an amount of up to 20%, e.g. 2 to 20%, by weight based on the total weight of vinylic resin, solvent, wax, semi-conductive particles and, if present, conductive particles. For best results, a preferred range of about 2% to 8% by weight is recommended, and most preferably about 5% by weight.

0161805

The vinylic resin of the composition serves as a matrix for the conductive and/or semiconductive particles. Film coatings produced with these resins exhibit excellent flexibility and tear resistance. A suitable vinylic resin commercially available is Borden Vinyl VC 410M, manufactured by Borden Chemical, a Division of Borden, Inc. Other vinylic resins may be used which provide the desired strength and flexibility. For example, the vinylic resin may be one or more of polyvinyl chloride, polyvinylidene chloride, polyvinyl acetate, polyvinyl alcohol and polyvinyl acetal homopolymers, copolymers of vinyl chloride with vinyl acetate, and copolymers of vinyl chloride with vinylidene chloride can also be employed. The aforesaid vinylic resins may also be used in combination with one or more other conventional copolymerizable monomeric, oligomeric and prepolymeric compounds. Such admixtures of vinylics with other monomers can be employed to control viscosity and/or rate of cure, as well as such variables as hardness and flexibility.

The vinylic resin should be present in the amount of 5% to 20% by weight, based on the total weight of the vinylic resin, solvent, wax, and conductive and/or semi-conductive particles. Preferably, the vinylic resin is present in an amount of 10% by weight.

The solvent operable in the present invention is most preferably gamma butyrolactone. Other suitable solvents include, for example, methyl n-propyl ketone, methyl isopropyl ketone and acetylacetone. The solvent is suitably present in the final composition in an amount of about 20% to 60%, preferably about 40%, by weight, based on the total weight of the vinylic resin, solvent, wax, and conductive and/or semi-conductive particles.

The wax contributes peelability to the composition. The wax employed in the present invention may be microcrystalline material and may be selected from a wide variety of synthetic or natural types. For example, cetyl, ceryl, or melissyl esters are suitable. A commercially available wax, useful in the composition, is Ross Wax No. 1972, manufactured by Frank B. Ross Co., Inc.

The amount of wax in the composition is important to the intended use of the invention. A certain amount of wax is required to achieve the desired peelability of the film. The wax serves as a releasing agent which permits the film to be readily removed. However, it has been found that too much wax will adversely affect the cohesive strength of the film. Consequently, the film may not adequately protect the coated substrate.

The wax is suitably present in an amount by weight of 2% to 6% by weight, based on the total weight of the vinylic resin, solvent, wax, and conductive and/or semi-conductive particles. A preferred amount is about 4% by weight. The ratio of resin to wax is from 4:1 to about 2:1, preferably from about 2.5:1 to 3.5:1, and most preferably about 3:1.

The composition of the present invention may, for example, include fluorescent pigment, which permits the film conductor or resistor to be visible under ultraviolet light. The inclusion of such pigment permits the observation and inspection of the coated areas of the substrate and circuit, both before and after removal of the film. Inspection following peeling off assures that the substrate is completely clean of the film, whereas inspection before peeling assures that there are no bald spots or undesired blotches on the substrate. The use of fluorescent pigment is especially suitable in the case of the invention being applied to electronic devices sensitive to ambient light.

A preferred fluorescent pigment is Dayglow Z-14 IMP, manufactured by Day-Glo Color Corp. This pigment may suitably be present in the composition in an amount by weight of about 0.1 to 1.0%, preferably in an amount of about 0.1%, by weight, based on the total weight of fluorescent pigment, vinylic resin, solvent, wax, and conductive and/or semi-conductive particles.

The composition of the present invention may optionally include one or more conventional additives such as antioxidants, inhibitors, fillers, antistatic agents, thickeners, viscosity modifiers, plasticizers, and tackifiers. These additives may be present in effective amounts, as will be known to those skilled in the art.

The film coating produced using the composition of the present invention will usually be a "thick film" as this term is understood in the art.

The composition of the present invention may be prepared by combining and homogenizing the components thereof, and the product thus formed can be referred to as an ink. For example, the organic resin may be admixed with the solvent and the wax under high sheer stirring, the conductive and/or semiconductive particles then being added. For complete homogenization, the mixture can be passed through a three roller mill.

According to a further aspect of the present invention there is provided a method for making an electrical conductor or resistor having desired conductivity and capable of being removed from a substrate by peeling, comprising the steps of:

(a) forming a composition according to the invention by mixing the vinylic resin, solvent and wax with the conductive and/or semiconductive particles,

(b) applying the mixture of step (a) to a substrate to form a film thereon,

(c) heat curing said film at an elevated temperature until said film is solidified to form said conductor or resistor, said conductor or resistor being capable of being removed from said substrate by peeling.

The composition of the invention can be applied to a substrate, e.g. an electric circuit, by screen printing, dipping or brushing. Curing occurs by heating, for example, to about 150°C for about 5 minutes. The curing cycle may range from about 2 to 180 minutes and the temperature may range from about 125 to 165°C, which is sufficient to fully cure the composition to a solid.

According to a further aspect of the present invention there is provided an article comprising a substrate carrying an electrical conductor or resistor having a desired conductivity, said conductor or resistor being formed from a composition according to the invention and comprising a matrix of the vinylic resin and wax, and the conductive and/or semiconductive particles, selected to provide the desired conductivity of said conductor or resistor, being disposed in said matrix, the ratio of the vinylic resin to the wax being 2:1 to 4:1 to permit the conductor or resistor to be removed from said substrate by peeling.

The composition of the invention can be used to form temporary conductors in a circuit. For example, in order to protect electronic devices, temporary electrical shorts may be inserted at strategic locations. The composition of the invention can alternatively be used to form a temporary resistor coating which can be used as an insulator to shield an electronic device. For example, during testing of the device, a temporary resistor coating may be applied to sensitive portions thereof.

According to a still further aspect of the present invention there is provided a cured composition adapted to form an electrical conductor or resistor on a substrate, said conductor or resistor having a desired conductivity and being capable of being removed from said substrate by peeling therefrom, said composition comprising:-

    (i)   vinylic resin;

    (ii)  wax; and

- 9 -                    0161805

(iii) conductive and/or semi-conductive particles,
       selected to provide the desired conductivity of
       said conductor or resistor;
the ratio of said vinyl resin to said wax being in the range
of 2:1 to 4:1 to allow the conductor or resistor to be
removed from said substrate by peeling.

The present invention will now be further illustrated
by way of the following examples which are presented for
purposes of exemplification only and are not intended to
limit the scope of the present invention.  Unless otherwise
noted all percentages and parts are by weight.

### Example I

In a Hobart Model N-50 mixer were admixed the
following:  40% gamma butyrolactone, 12.8% Borden Vinyl
VC-410M, 4.3% Ross Wax No. 1972, and 42.9% silver flake.
The mixture was further homogenized in a three roller mill.
The resulting composition was screen printing onto a
substrate.  Subsequently, the printed film was cured at
about 150°C for about 5 minutes.  The film thus obtained
exhibited a conductivity of 0.1 ohm/sq.  The film was
readily peeled off.

### Example II

A composition consisting of 54 parts gamma
butyrolactone, 27 parts Borden Vinyl VC 401M, 9 parts Ross
Wax 1972 and 10 parts graphite particles was mixed in a
Hobart N-50 mixer and then homogenized in a three roller
mill.  This composition was screen printed onto a substrate
and subsequently cured at a temperature of 150°C for a
period of 5 minutes.  The printed film exhibited a
conductivity of 500K ohm/sq.  The film was readily peeled
off 24 hours later.

CLAIMS:

1. A composition adapted to form an electrical conductor or resistor on a substrate, said conductor or resistor having a desired conductivity and being capable of being removed from said substrate by peeling therefrom, said composition comprising

    (i) 5-20% by weight vinylic resin;

    (ii) 2 to 6% by weight wax,

    (iii) 20 to 60% by weight solvent, and

    (iv) up to 60% by weight of conductive particles and/or up to 20% by weight of semiconductive particles, selected to provide the desired conductivity of said conductor or resistor,

the above percentages being based on the total weight of (i), (ii), (iii) and (iv), and the weight ratio of said vinylic resin to said wax being in the range of 2:1 to 4:1 to allow the conductor or resistor to be removed from said substrate by peeling.

2. A composition as claimed in claim 1, in which 20 to 60% by weight of the conductive particles and/or 2 to 20% by weight of the semi-conductive particles are present.

3. A composition as claimed in claim 1 or claim 2, in which the weight ratio of said vinylic resin to said wax is in the range of 2.5:1 to 3.5:1.

4. A composition as claimed in any of claims 1 to 3, in which said vinylic resin is one or more of polyvinyl chloride, copolymers of vinyl chloride and vinyl acetate, and copolymers of vinyl chloride and vinylidene chloride.

5. A composition as claimed in any of claims 1 to 4, in which said conductive particles comprise one or more of gold, silver, platinum and nickel particles.

6. A composition as claimed in any of claims 1 to 5 in which said semi-conductive particles comprise carbon particles.

7. A composition as claimed in any of claims 1 to 6 which further comprises fluorescent pigment.

8.    A method for making an electrical conductor or resistor having desired conductivity and capable of being removed from a substrate by peeling, comprising the steps of:

    (a) forming a composition as claimed in any of claims 1 to 7 by mixing the vinylic resin, solvent and wax with the conductive and/or semiconductive particles,

    (b) applying the mixture of step (a) to a substrate to form a film thereon,

    (c) heat curing said film at an elevated temperature until said film is solidified to form said conductor or resistor, said conductor or resistor being capable of being removed from said substrate by peeling.

9.    An article comprising a substrate carrying an electrical conductor or resistor having a desired conductivity, said conductor or resistor being formed from a composition as claimed in any of claims 1 to 7 and comprising a matrix of the vinylic resin and wax, and the conductive and/or semiconductive particles, selected to provide the desired conductivity of said conductor or resistor, being disposed in said matrix, the ratio of the vinylic resin to the wax being 2:1 to 4:1 to permit the conductor or resistor to be removed from said substrate by peeling.

10.    A cured composition adapted to form an electrical conductor or resistor on a substrate, said conductor or resistor having a desired conductivity and being capable of being removed from said substrate by peeling thereform, said composition comprising:-

    (i)    vinylic resin;

    (ii)   wax; and

    (iii)  conductive and/or semi-conductive particles, selected to provide the desired conductivity of said conductor or resistor;

0161805

the ratio of said vinylic resin to said wax being in the range of 2:1 to 4:1 to allow the conductor or resistor to be removed from said substrate by peeling.

11. A cured composition as claimed in claim 10, in which the vinylic resin is one or more of polyvinyl chloride, copolymers of vinyl chloride and vinyl acetate, and copolymers of vinyl chloride and vinylidene chloride.

12. A cured composition as claimed in claim 10 or claim 11, in which the conductive particles comprise one or more of gold, silver, platinum and nickel particles.

13. A cured composition as claimed in any of claims 10 to 12, in which the semi-conductive particles comprise carbon particles.

14. A cured composition as claimed in any of claims 10 to 13, which further comprises fluorescent pigment.

0161805

EUROPEAN SEARCH REPORT

European Patent Office

Application number

EP 85 30 2569

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 077 957 (NIPPON UNICAR) <br> * Claims 1-11 * <br><br> ----- | 1 | H 01 B 1/22 <br> H 01 B 1/24 |
| | | | TECHNICAL FIELDS SEARCHED (Int. Cl.4) |
| | | | H 01 B <br> H 01 C |

The present search report has been drawn up for all claims

| Place of search | Date of completion of the search | Examiner |
|---|---|---|
| THE HAGUE | 19-07-1985 | DROUOT M.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82